# EUROPÄISCHE PATENTSCHRIFT

(11) **EP 0 944 749 B1**
(45) Veröffentlichungstag und Bekanntmachung des Hinweises auf die Patenterteilung: **08.08.2001**
(21) Anmeldenummer: 97952879.1
(22) Anmeldetag: 04.12.1997
(51) Int. Cl.: C25D 3/38, C25D 5/18, H05K 3/24

(54) **VERFAHREN ZUR ELEKTROLYTISCHEN ABSCHEIDUNG VON KUPFERSCHICHTEN**
PROCESS FOR THE ELECTROLYTIC DEPOSITION OF COPPER LAYERS
PROCEDE DE DEPOSITION ELECTROLYTIQUE DE COUCHES DE CUIVRE

(30) Priorität: 13.12.1996 DE 19653681
(43) Veröffentlichungstag der Anmeldung: 29.09.1999
(73) Patentinhaber: ATOTECH Deutschland GmbH, 10553 Berlin (DE)
(72) Erfinder: SENGE, Gerd, D-13409 Berlin (DE); DAHMS, Wolfgang, D-13437 Berlin (DE)
(74) Vertreter: Effert, Bressel und Kollegen
(86) Internationale Anmeldenummer: EP9706786
(87) Internationale Veröffentlichungsnummer: WO9826114

(56) Entgegenhaltungen:
- EP-A- 0 402 896
- GB-A- 662 217
- PATENT ABSTRACTS OF JAPAN vol. 097, no. 007, 31.Juli 1997 & JP 09 067693 A (NIKKO GOULD FOIL KK), 11.März 1997,

## Beschreibung

Die Erfindung betrifft ein Verfahren zur elektrolytischen Abscheidung von Kupferschichten mit kurzer Einarbeitungszeit, insbesondere für die Leiterplattenherstellung.

An die Kupferabscheidung für die Leiterplattenherstellung werden verschiedene Anforderungen gestellt: Zum einen müssen die Kupferschichten bestimmten Anforderungen an die Materialeigenschaften genügen. Beispielsweise dürfen sich in den Schichten unter Thermoschockbedingungen (mindestens einmaliges 10 sec langes Eintauchen in flüssiges Zinn/Blei-Lot bei 288°C) keine Risse bilden. Ferner müssen die Kupferschichten glänzend und glatt sein und an allen Stellen der zu beschichtenden Oberflächen auch möglichst gleichmäßig dick sein. Darüber hinaus muß das Abscheideverfahren leicht beherrschbar und wirtschaftlich sein.

Zur elektrolytischen Kupferabscheidung werden üblicherweise aus Kupfer bestehende Anoden eingesetzt, die sich beim elektrolytischen Abscheiden auflösen. Diese Anoden werden in Form von Platten, Barren oder Kugeln verwendet. Die Platten und Barren werden mittels geeigneter Befestigungsmittel an den Stromzuführungen angebracht. Die Kugeln werden in hierfür eigens bereitgestellten, meist aus Titan gefertigten Körben, die ihrerseits mittels geeigneter Befestigungsmittel an den Stromzuführungen angebracht sind, gehalten.

Da sich diese Anoden während des Abscheideprozesses in etwa in dem Umfang auflösen, wie Kupfer aus dem Abscheidebad abgeschieden wird, bleibt der Kupfergehalt in der Abscheidelösung ungefähr konstant. Eine Ergänzung des abgeschiedenen Kupfers ist daher nicht erforderlich.

Zum Erzielen von bestimmten Materialeigenschaften der elektrolytisch abgeschiedenen Schichten werden dem Abscheidebad Zusätze in geringen Mengen beigefügt. Hierbei handelt es sich vorwiegend um organische Stoffe, die in der Regel unter den bei der Leiterplattenherstellung üblicherweise eingestellten Abscheidebedingungen geringfügig verbraucht werden. Zur Einhaltung vorgegebener Qualitätsmerkmale wird der dadurch verursachte Verlust an organischen Zusätzen entsprechend ergänzt. Die Zusätze verbessern die Metallstreuung, das heißt die Gleichmäßigkeit der Kupferschichtdicke an allen zu beschichtenden Oberflächen, nur wenig.

Einen anderen Anodentyp stellen unlösliche Anoden dar, deren äußere geometrische Form sich beim Abscheideprozeß nicht verändert. Diese Anoden bestehen aus inerten Metallen, beispielsweise Titan oder Blei, die jedoch zur Vermeidung hoher anodischer Überspannungen mit katalytisch wirksamen Metallen, beispielsweise Platin, beschichtet werden können.

Bei Verwendung unlöslicher Anoden müssen zur Aufrechterhaltung der Kupferionenkonzentration im Abscheidebad geeignete Maßnahmen getroffen werden, beispielsweise durch Nachführen über hierfür geeignete Lösungen, die die Kupferionen in konzentrierter Form enthalten. Eine kürzlich vorgeschlagene Ergänzungsmöglichkeit besteht darin, die Kupferionen durch chemische Auflösung von Kupferteilen in einem separaten Behandlungsbehälter mittels zusätzlich zugegebener Eisen-(III)-ionen oder anderer Metallionen, die auf Kupfer oxidierend wirken, zu ergänzen (DD 215 589 B5, DD 261 613 A1, DE-P 43 44 387 A1). Die durch die Kupferauflösung gebildeten Eisen-(II)-ionen werden an den Anoden zu Eisen-(III)-ionen reoxidiert und die mit Kupferionen angereicherte Lösung zur Kupferabscheidung an das Substrat transportiert. Durch fortwährende Zirkulation der Abscheidelösung zwischen Abscheidebehälter und Behandlungsbehälter, in dem sich die Kupferteile befinden, wird ein stationäres Gleichgewicht der Kupferionenkonzentration eingestellt. Die hinzugefügten Eisenionen unterdrücken auch die oxidative Zersetzung der organischen Verbindungen, die zur Steuerung der Materialeigenschaften der abgeschiedenen Kupferschichten zugegeben werden. Werden die Bäder mit unlöslichen Anoden ohne diese Ionen betrieben, kommt es zu sehr schneller Zersetzung dieser Verbindungen, so daß brauchbare Metallschichten überhaupt nicht erhalten werden können.

Das Verfahren unter Verwendung der unlöslichen Anoden ist aufwendig und benötigt zur Konstanthaltung der Kupferionenkonzentration eine genaue Einstellung der Konzentration der Eisenionen, der Zirkulationsgeschwindigkeit der Abscheidelösung, der Oberfläche der Kupferteile und deren Morphologie sowie weiterer Parameter in Abhängigkeit vom gewählten Kupferabscheidestrom. Ferner können sich an den unlöslichen Anoden unter ungünstigen Verhältnissen auch die dem Abscheidebad zugegebenen Zusätze zur Beeinflussung der Materialeigenschaften der Kupferschichten zersetzen, so daß diese Eigenschaften nicht zuverlässig erreicht werden können. Ferner wird auch beobachtet, daß durch den Zusatz der Eisenionen die Gleichmäßigkeit der Kupferschichtdicke auf Leiterplattenaußenseiten und den Mantelflächen der Bohrlöcher unter den in den vorgenannten Druckschriften beschriebenen Bedingungen verschlechtert wird. Daher ist ein Verfahren vorzuziehen, bei dem lösliche Anoden eingesetzt werden.

Wird anstelle von Gleichstrom mit einem Pulsstrom- oder Pulsspannungsverfahren (Pulse Plating) gearbeitet, so wird die Metallstreuung in der Regel verbessert (WO-A-89/07162, "Pulse Plating of Copper for Printed Circuit Board Technology", M.R.Kalantary, D.R.Gabe, M.Goodenough, Metal Finishing, 1991, Seiten 21-27). Bei der Kupferabscheidung auf Leiterplatten werden insbesondere auch in kleinen Bohrlöchern ausreichend dicke Metallschichten erreicht, obwohl dort die lokale Stromdichte gering ist.

Nachteilig ist jedoch, daß beim Zubereiten des Bades trotz Zugabe organischer Additive zur Verbesserung der Materialeigenschaften der Kupferschichten nur rauhes Kupfer bei der Abscheidung, teilweise mit Dendritenstruktur, erhalten werden kann. Die Oberflächen der solcherart abgeschiedenen Schichten fühlt sich rauh an und sieht matt und ungleichmäßig scheckig aus. Überdies ist die Duktilität dieser Schichten sehr gering, so daß bereits bei einem Thermoschock, wie er beim Löten auftritt, Risse in der Kupferschicht auftreten.

Dieses Verhalten verbessert sich nach längerer Zeitspanne nach dem Neuansatz des Bades, innerhalb der kontinuierlich Kupfer aus dem Bad abgeschieden und fortwährend die Badkomponenten entsprechend dem normalen Verbrauch ergänzt werden. Hierfür ist je nach Auslastung des Bades ein Zeitraum von 7 bis 14 Tagen und gegebenenfalls auch ein längerer Zeitraum anzusetzen, wobei ein Stromdurchgang von 50 bis 100 A·h/l Abscheidebad notwendig ist ("Analytik von sauren Kupferbädern", B.Bressel, Galvanotechnik, 76 (1985), Seite 1972). Während dieser Zeit weisen die Leiterplatten derart unbefriedigende optische und mechanische Eigenschaften auf, daß sie unbrauchbar sind. Durch die lange Einarbeitungszeit des Abscheidebades werden auch erhebliche Kosten verursacht.

Der Erfindung liegt von daher das Problem zugrunde, ein Verfahren zu finden, mit dem die Nachteile der bekannten Verfahren vermieden werden und mit dem insbesondere eine wirtschaftliche Arbeitsweise möglich ist. Die abgeschiedenen Kupferschichten sollen sowohl an allen Stellen der zu beschichtenden Oberflächen möglichst gleichmäßig dick sein als auch hinreichend gute optische und mechanische Materialeigenschaften (beispielsweise hinsichtlich Glanz, Bruchelongation, Zugfestigkeit) aufweisen. Es soll auch möglich sein, Schichten mit einer Dicke von etwa 25 µm auf den Außenseiten und in den Bohrlöchern von Leiterplatten herzustellen, die auch ein mehrmaliges 10 sec langes Eintauchen in ein 288°C heißes Lotbad ohne Risse überstehen. Die genannten Eigenschaften sollen vor allem bereits nach einem sehr kurzen Abscheidezeitraum nach dem Zubereiten des Bades erreichbar sein (kurze Einarbeitungsphase), beispielsweise bereits nach einem Ladungsaustausch von weniger als 10 A·h/l (Ampere-Stunden/Liter), vorzugsweise von weniger als 1 A·h/l.

Das Problem wird gelöst durch ein Verfahren nach Anspruch 1. Vorteilhafte Ausführungen der Erfindung sind in den Unteransprüchen angegeben.

Es hat sich gezeigt, daß die Einarbeitungszeit eines Abscheidebades mit Kupferionen, mindestens einer die Materialeigenschaften des abgeschiedenen Metalls beeinflussenden Verbindung und mindestens einem Lösungsmittel oder Lösungsmittelgemisch, das heißt der Zeitraum, in dem brauchbare Kupferschichten nach dem Neuansatz aus dem Abscheidebad noch nicht abgeschieden werden können, bei Verwendung von mindestens einer löslichen Anode, beispielsweise aus Kupfer, und unter Verwendung eines Pulsstrom- oder Pulsspannungsverfahren drastisch verkürzt werden kann, so daß brauchbare Schichten bereits nach einem Ladungsaustausch von 10 A·h/l und vorzugsweise 5 A·h/l erhalten werden können, wenn der Abscheidelösung geringe Mengen von Eisenionen zugesetzt werden. Man benötigt unter diesen Voraussetzungen häufig sogar weniger als 1 A·h/l zur Einarbeitung des Bades, um eine gute Verkupferung der Leiterplatten zu erreichen. Die Einarbeitungszeit kann in günstigen Fällen auch vollständig entfallen.

Als Ursache der unerwarteten Wirkung der Zugabe von Eisenionen wird die katalytische Wirkung dieser lonen auf die Oxidation der im Abscheidebad vorhandenen und an der Kathode reduzierten, als Glanzzusätze verwendeten organischen Schwefelverbindungen, die dem Bad üblicherweise zugegeben werden, vermutet.

Die erfindungsgemäße Wirkung ist auch zu beobachten, wenn Verbindungen anderer Redoxsysteme in geringen Mengen vorliegen. Neben Eisenverbindungen sind Verbindungen der Elemente Arsen, Cer, Chrom, Kobalt, Gold, Mangan, Molybdän, Platin, Ruthenium, Samarium, Titan, Vanadin, Wolfram und Zinn ebenfalls geeignet.

Um das erfindungsgemäße Problem zu lösen, ist es ausreichend, dem Abscheidebad die genannten Verbindungen in einer Konzentration von 3 bis 500 mg/l Abscheidebad, vorzugsweise 25 bis 100 mg/l, zuzugeben, wobei diese Konzentrationsangaben auf die Menge des vorgenannten Elements in der Verbindung im Abscheidebad bezogen sind.

Vorzugsweise wird dem Bad eine Eisenverbindung zugegeben. Hierbei spielt es keine Rolle, ob dem Bad Eisen-(II)- oder Eisen-(III)-ionen zugemischt werden. Aus den dem Bad zugegebenen Eisen(II)- oder Eisen(III)-verbindungen stellt sich nach kurzer Betriebszeit ein Gleichgewicht von beiden Verbindungen ein.

Werden dann, wie nachstehend beschrieben, die üblichen Glanzzusätze und Netzmittel und weiteren üblichen Zusatzstoffe dem Elektrolyten zugesetzt, so wird die Einarbeitungszeit bei Anwendung von Pulsströmen drastisch verkürzt, oder sie entfällt. Durch die Zugabe wird die Bildung von Rauhigkeiten und von matten Kupferoberflächen vermieden. Außerdem überstehen die aus diesen Bädern abgeschiedenen Kupferschichten auch einen mehrmaligen Lötschocktest (10 sec bei 288°C) ohne das Auftreten von Rissen. Das Verfahren weist überdies den Vorteil auf, daß die abgeschiedenen Kupferschichten an allen Stellen der beschichteten Oberflächen gleichmäßig dick sind und nicht wie bei den bekannten Verfahren unter Zusatz von Eisenionen zum Kupferbad eine ungleichmäßige Dicke aufweisen.

Als die erfindungsgemäße Wirkung hervorrufende Verbindungen können die Acetate, Bromide, Carbonate, Chloride, Fluoride, Sulfate, Tetrafluorborate, Phosphate, Perchlorate, Citrate, Fumarate, Gluconate, Methansulfonate und Oxalate des Eisen-(II)- oder Eisen-(III)-ions oder der anderen vorgenannten Elemente verwendet werden.

Erfindungsgemäße Eisenverbindungen sind in Tabelle 1 aufgelistet.

Andere Verbindungen, die auch mit Erfolg getestet wurden, sind in Tabelle 2 aufgelistet. Ihre Anwendung ist aber wegen ihrer hohen Kosten beschränkt.

Die Grundzusammensetzung des Kupferbades kann in weiten Grenzen schwanken. Im allgemeinen wird eine wäßrige Lösung folgender Zusammensetzung benutzt:

| | |
|---|---|
| Kupfersulfat (CuSO₄. 5H₂O) | 20 bis 250 g/l |
| vorzugsweise | 80 bis 140 g/l oder |
| | 180 bis 220 g/l |
| Schwefelsäure | 50 bis 350 g/l |
| vorzugsweise | 180 bis 280 g/l oder |
| | 50 bis 90 9/l |
| Chloridionen | 0,01 bis 0,18 g/l |
| vorzugsweise | 0,03 bis 0,10 g/l |

Anstelle von Kupfersulfat können zumindest teilweise auch andere Kupfersalze benutzt werden. Auch die Schwefelsäure kann teilweise oder ganz durch Fluoroborsäure, Methansulfonsäure oder andere Säuren ersetzt werden. Die Chloridionen werden als Alkalichlorid (z.B. Natriumchlorid) oder in Form von Salzsäure p.A. zugesetzt. Die Zugabe von Natriumchlorid kann ganz oder teilweise entfallen, wenn in den Zusätzen bereits Halogenidionen enthalten sind.

Außerdem können im Bad übliche Glanzbildner, Einebner, Netzmittel oder weitere übliche Zusätze enthalten sein. Um glänzende Kupferniederschläge mit bestimmten Materialeigenschaften zu erhalten, werden zu dem Abscheidebad mindestens eine wasserlösliche Schwefelverbindung, vorzugsweise eine wasserlösliche organische Schwefelverbindung, und eine sauerstoffhaltige, hochmolekulare Verbindung zugegeben. Zusätze, wie stickstoffhaltige Schwefelverbindungen, polymere Stickstoffverbindungen und/oder polymere Phenazoniumverbindungen, sind ebenfalls verwendbar.

Diese Einzelkomponenten sind innerhalb folgender Grenzkonzentrationen im anwendungsfertigen Bad enthalten:

| | |
|---|---|
| Übliche sauerstoffhaltige, hochmolekulare Verbindungen | 0,005 bis 20 g/l |
| vorzugsweise | 0,01 bis 5 g/l |
| übliche wasserlösliche organische Schwefelverbindungen | 0,0005 bis 0,4 g/l |
| vorzugsweise | 0,001 bis 0,15 g/l. |

In Tabelle 3 sind beispielhaft sauerstoffhaltige, hochmolekulare Verbindungen aufgeführt. In der Tabelle 4 sind einige verwendbare Schwefelverbindungen wiedergegeben. Zur Wasserlöslichkeit sind entsprechende funktionelle Gruppen in den Verbindungen enthalten.

Thioharnstoffderivate und/oder polymere Phenazoniumverbindungen und/oder polymere Stickstoffverbindungen werden in folgenden Konzentrationen eingesetzt:

| | |
|---|---|
| | 0,0001 bis 0,50 g/l |
| vorzugsweise | 0,0005 bis 0,04 g/l. |

Zur Herstellung des Bades werden die Einzelkomponenten der Grundzusammensetzung hinzugefügt. Die Arbeitsbedingungen des Bades sind wie folgt:

| | |
|---|---|
| pH-Wert: | < 1, |
| Temperatur: | 15°C bis 50°C |
| vorzugsweise | 25°C bis 40°C |
| kathodische Stromdichte: | 0,5 bis 12 A/dm² |
| vorzugsweise | 3 bis 7 A/dm². |

Der Pulsstrom wird durch einen geeigneten Pulsgenerator erzeugt. Beim Pulsstromverfahren wird der Strom zwischen den als Kathoden polarisierten Werkstücken, beispielsweise Leiterplatten, und den Anoden galvanostatisch eingestellt und mittels geeigneter Mittel zeitlich moduliert. Die Spannung zwischen den Kathoden und den Anoden stellt sich daraufhin automatisch ein. Beim Pulsspannungsverfahren wird eine Spannung zwischen den Werkstücken und den Anoden potentiostatisch eingestellt und die Spannung zeitlich moduliert, so daß sich eine zeitlich veränderliche Spannung einstellt. In diesem Fall stellt sich der Strom automatisch ein.

Mit dem Pulsstromgenerator können kathodische Strompulse und anodische Strompulse erzeugt und der Strom kurzzeitig auch auf Null eingestellt werden. Hierbei sollten die anodischen Pulse mindestens genauso hoch sein wie die kathodischen Pulse. Vorzugsweise sollten die anodischen Pulse jedoch zwei- bis dreimal höher sein als die kathodischen Strompulse. Insgesamt muß die Ladungsmenge, die während der (kathodischen) Abscheidephase fließt, deutlich größer sein als die Ladungsmenge in der anodischen Phase.

Die Pulse sollten eine Dauer von 0,1 msec bis 1 sec haben. Bevorzugte Pulsdauern betragen 0,3 msec bis 30 msec, wobei die kathodischen Pulse vorzugsweise eine Dauer von 10 msec bis 30 msec und die anodischen Strompulse eine Dauer von 0,3 msec bis 10 msec, insbesondere von 0,3 msec bis 3 msec aufweisen. Eine besonders günstige Strommodulation ist folgende: Die kathodische Phase dauert 10 msec, die anodische 0,5 msec. Eine verbesserte Einstellung entsteht, wenn jeweils zwischen einem kathodischen Puls (Dauer 5 msec) alternativ eine Pause (Dauer 5 msec), bei der der Strom auf Null eingestellt wird, oder ein anodischer Puls (Dauer 1 msec) auftritt. In einem Zyklus können mehrere kathodische oder anodische Pulse unterschiedlicher Höhe eingestellt werden. Geräte zur Erzeugung dieser Modulationsformen sind bekannt.

Das Abscheidebad wird durch starke Anströmung und gegebenenfalls durch Einblasen von sauberer Luft derart bewegt, daß sich die Badoberfläche in starker Bewegung befindet. Dadurch wird der Stofftransport in der Nähe der Kathoden und Anoden maximiert, so daß größere Stromdichten ermöglicht werden. Auch eine Bewegung der Kathoden bewirkt eine Verbesserung des Stofftransportes an den jeweiligen Oberflächen. Durch die erhöhte Konvektion und Elektrodenbewegung wird eine konstante diffusionskontrollierte Abscheidung erzielt. Die Substrate können horizontal, vertikal und/oder durch Vibration bewegt werden. Eine Kombination mit der Lufteinblasung in das Abscheidebad ist besonders wirksam.

Das beim Abscheideprozeß verbrauchte Kupfer wird elektrochemisch über die Kupferanoden ergänzt. Für die Anoden wird Kupfer mit einem Gehalt von 0,02 bis 0,067 Gewichts-% Phosphor verwendet.

In den Elektrolytkreisläufen können bedarfsweise Filter zur Entfernung mechanischer und/oder chemischer Rückstände vorgesehen sein. Der Bedarf ist im Vergleich zu elektrolytischen Zellen mit löslichen Anoden geringer, weil der durch den Phosphorgehalt der Anoden entstehende Schlamm nicht gebildet wird.

Üblicherweise werden Beschichtungsanlagen eingesetzt, bei denen das Behandlungsgut während des Abscheideprozesses in vertikaler oder horizontaler Lage gehalten wird. Das Verfahren wird vorzugsweise zur Herstellung von Leiterplatten eingesetzt. Eine andere Anwendungsmöglichkeit besteht beim Verkupfern von Teilen zu dekorativen Zwecken, beispielsweise von Sanitärarmaturen, Automobilteilen und Möbelbeschlägen.

Die folgenden Beispiele und Vergleichsbeispiele dienen zur Erläuterung der Erfindung:

### Vergleichsbeispiel 1:

In einer Elektrolysezelle mit löslichen, phosphorhaltigen Kupferanoden wurde ein Kupferbad mit folgender Zusammensetzung eingesetzt:
80 g/l Kupfersulfat (CuSO₄.5 H₂O),
180 g/l Schwefelsäure konz.,
0,08 g/l Natriumchlorid,
mit folgenden Glanzbildnern
1,5 g/l Polypropylenglycol,
0,006 g/l 3-Mercaptopropan-1-sulfonsäure, Natriumsalz,
0,001 g/l N-Acetylthioharnstoff.

Bei einer Elektrolyttemperatur von 25°C wurden auf gebürstetem Kupferlaminat Kupferschichten mit pulsierendem Strom mit den nachfolgenden Verfahrensparametern abgeschieden:

| | | |
|---|---|---|
| Strom kathodisch | Höhe: 4 A/dm² | Dauer: 10 msec, |
| danach Strom anodisch | Höhe: 8 A/dm² | Dauer: 0,5 msec. |

Es wurden Kupferschichten mit einer rauhen, matten Oberfläche erhalten. Die Bruchelongation einer daraus abgeschiedenen Folie betrug nur 14 %. Bereits durch einen einmaligen Lötschocktest mit 10 sec Dauer bei 288°C wurden in einer auf einer Leiterplatte abgeschiedenen Kupfer schicht Risse an verschiedenen Stellen beobachtet. Die Kupferschicht erfüllte damit nicht den gewünschten Qualitätsstandard.

### Vergleichsbeispiel 2:

Vergleichsbeispiel 1 wurde wiederholt. Jedoch wurde die Abscheidung aus dem Bad über längere Zeit fortgesetzt und anschließend Kupfer aus diesem durchgearbeiteten Bad auf einer Leiterplatte abgeschieden (Ladungsdurchsatz 20 A·h/l Abscheidebad). Das Aussehen der Kupferschicht verbesserte sich gegenüber dem Versuch nach Vergleichsbeispiel 1 merklich. Die Kupferschicht auf der Leiterplatte sah nun glänzend aus und wies keine Rauhigkeiten mehr auf. Die Bruchelongation einer aus dem durchgearbeiteten Badabgeschiedenen Schicht verbesserte sich auf 18 %.

### Beispiel 1:

Dem Abscheidebad von Vergleichsbeispiel 1 wurden zusätzlich
200 mg/l Eisen-(II)-sulfat-Pentahydrat
bei Beginn der Abscheidung zugesetzt. Dadurch wurde beim Erzeugen einer Kupferschicht auf einer Leiterplatte bereits mit einem frisch angesetzten Bad ein überraschend gutes Aussehen der Kupferschicht auf der ersten beschichteten Leiterplatte erhalten (Glanz, keine Rauhigkeiten). Die Bruchelongation betrug 20 % nach einem Ladungsdurchsatz von 1 A·h/l Abscheidebad. Eine mit einer aus diesem Bad abgeschiedenen Kupferschicht überzogene Leiterplatte überstand einen zweimaligen Lötschocktest mit 10 sec Dauer bei 288°C, ohne daß Risse in der Kupferschicht beobachtet wurden. Die Kupferschicht war gleichmäßig glänzend. Ergebnis der Vergleichsbeispiele 1 und 2 sowie des Beispiels 1: Durch den Zusatz von Eisen-(II)-sulfat-Pentahydrat konnte die lange Einfahrphase, die bei Verwendung von Pulsstrom immer auftrat, eliminiert werden. Bereits nach kurzer Einarbeitungszeit des Bades mit einer durchgesetzten Ladungsmenge von 1 bis 2 A·h/l Abscheidebad konnte ein optimal arbeitendes Abscheidebad erhalten werden.

### Vergleichsbeispiel 3:

In einer Produktionsanlage für die Herstellung von Leiterplatten wurden Leiterplatten in einem Abscheidebad mit folgender Zusammensetzung verkupfert:
80 g/l Kupfersulfat (CuSO₄.5 H₂O),
200 g/l Schwefelsäure konz.

Als Glanzbildner wurden
1,0 g/l Polyethylenglycol,
0,01 g/l 3-(Benzthiazolyl-2-thio)-propylsulfonsäure, Natriumsalz
0,05 g/l Acetamid
zugegeben. Die Kupferschichten wurden mit pulsierendem Strom mit folgenden Parametern abgeschieden:

| | | | |
|---|---|---|---|
| 1. | Phase: Strom kathodisch | Höhe:6 A/dm² | Dauer: 5 msec |
| 2. | Phase: Stromlos | Höhe 0 A/dm² | Dauer 0,5 msec |
| 3. | Phase: Strom kathodisch | Höhe:6 A/dm² | Dauer: 5 msec |
| 4. | Phase: Strom anodisch | Höhe:10 A/dm² | Dauer: 1 msec. |

Bei einer Elektrolyttemperatur von 34°C wurden auf gebürstetem Kupferlaminat Kupferschichten mit matter Oberfläche erhalten, die sich sehr rauh anfühlten. Eine daraus abgeschiedene Leiterplatte überdauerte einen zweimaligen Lötschocktest nicht. Die Metallstreuung in einem Bohrloch mit 0.6 mm Durchmesser betrug lediglich 62 %.

### Beispiel 2:

Anschließend wurden dem Abscheidebad gemäß Vergleichsbeispiel 3 zusätzlich
200 mg/l Eisen-(III)-chlorid-Hexahydrat
zugeben. Daraufhin wurden auf Anhieb Kupferschichten mit guten optischen und mechanischen Materialeigenschaften erhalten. Die Kupferoberflächen waren gleichmäßig glänzend. Auch unter dem Mikroskop bei 40-facher Vergrößerung waren keine Dendriten zu erkennen. Eine mit diesen Schichten überzogene Leiterplatte wies nach einem fünfmaligen Lötschocktest keine Risse auf. Die Metallstreuung verbesserte sich auf 65 %.

Ergebnis des Vergleichsbeispiels 3 und des Beispiels 2: Durch die Zugabe von Eisenionen konnten die mangelhaften optischen und mechanischen Materialeigenschaften der Kupferschichten vermieden werden.

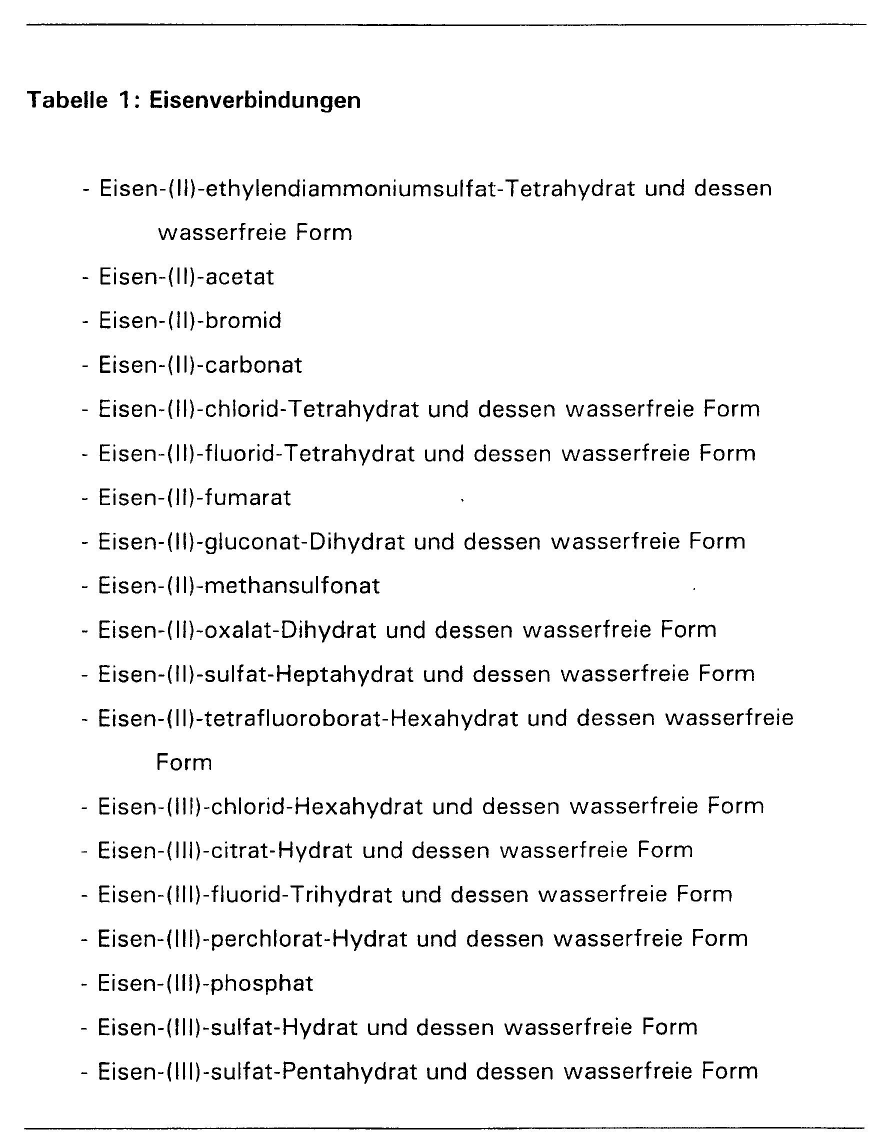

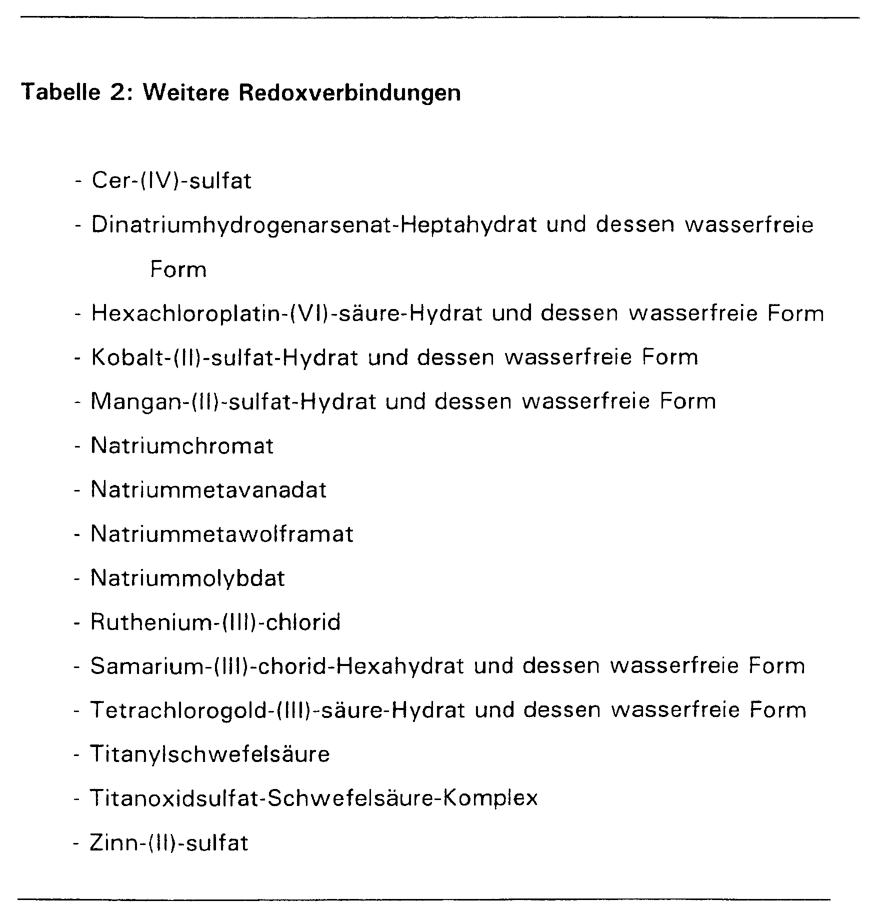

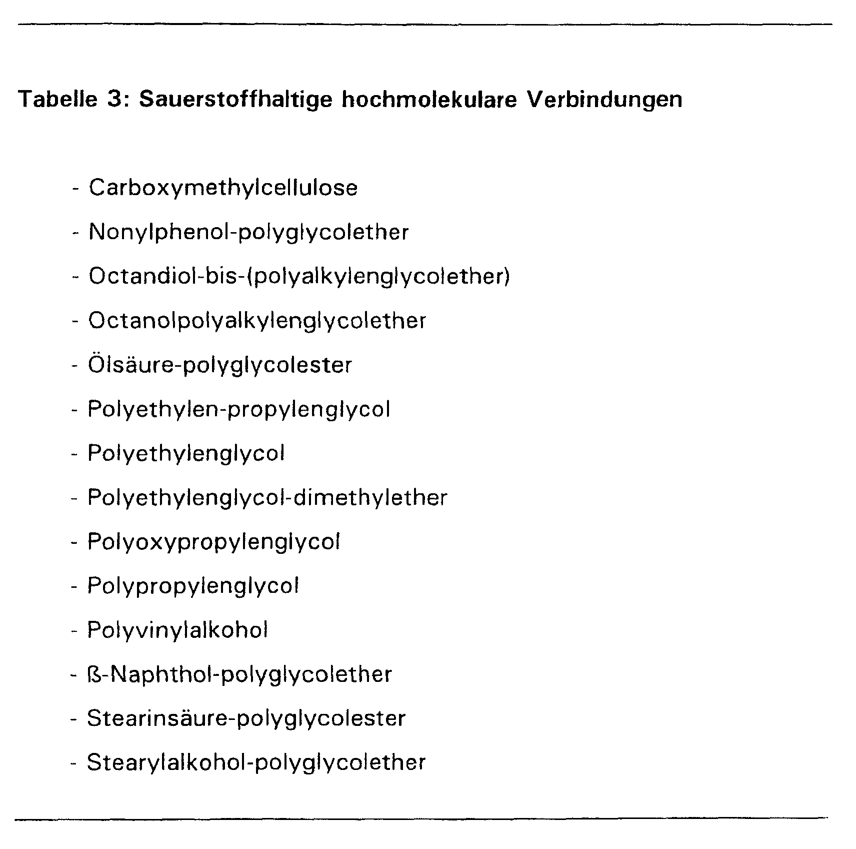

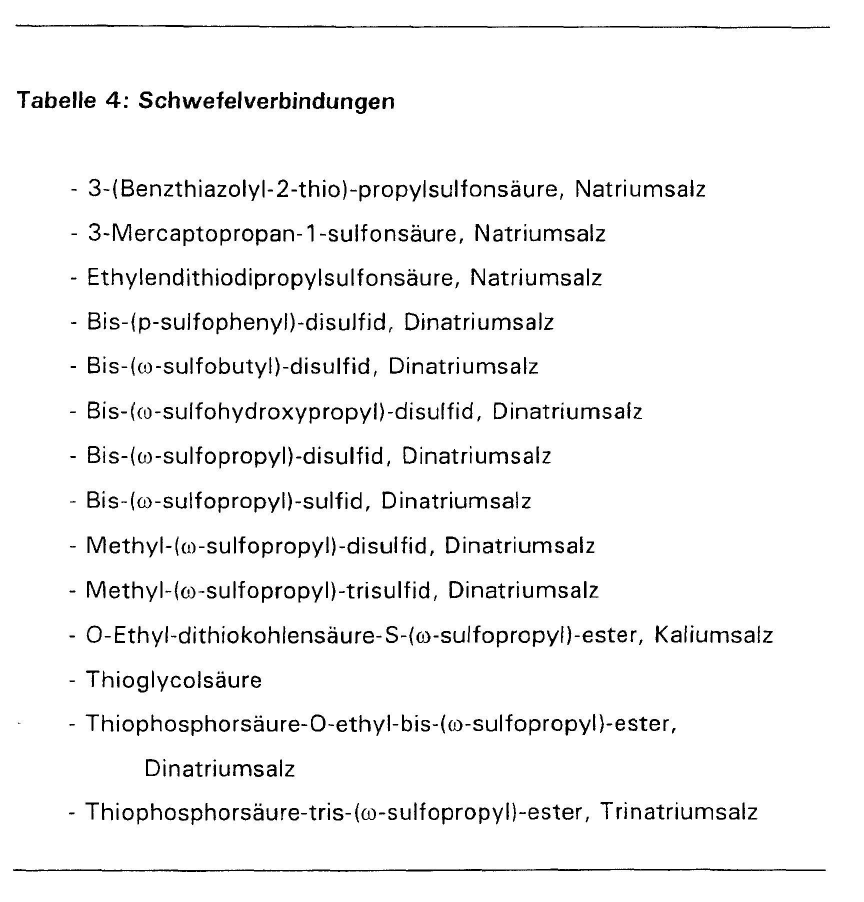

## Patentansprüche

1. Verfahren zum elektrolytischen Abscheiden von Kupferschichten mit kurzer Einarbeitungszeit mit folgenden Verfahrensschritten:
a. Zubereiten eines Abscheidebades, enthaltend Kupferionen, mindestens eine die elektrische Leitfähigkeit des Abscheidebades erhöhende Verbindung, mindestens einen Zusatz zur Beeinflussung der Materialeigenschaften der Kupferschichten, mindestens eine zusätzliche Verbindung eines elektrochemisch reversiblen Redoxsystems sowie ein Lösungsmittels oder Lösungsmittelgemisches,
b. In-Kontakt-bringen eines elektrisch leitfähigen Substrats und mindestens eine sich beim elektrolytischen Abscheiden auflösende Anode mit dem Abscheidebad,
c. Elektrisches Verbinden des Substrats und der Anoden mit einer Stromversorgung und Abscheiden der Kupferschichten auf dem Substrat mittels eines Pulsstrom- oder Pulsspannungsverfahrens.

2. Verfahren nach Anspruch 1, dadurch gekennzeichnet, daß als Verbindungen des elektrochemisch reversiblen Redoxsystems Verbindungen der Elemente Eisen, Arsen, Cer, Chrom, Kobalt, Gold, Mangan, Molybdän, Platin, Ruthenium, Samarium, Titan, Vanadin, Wolfram und/oder Zinn verwendet werden.

3. Verfahren nach einem der vorstehenden Ansprüche, dadurch gekennzeichnet, daß die Abscheidelösung die Verbindungen des Redoxsystems in einer Konzentration von 3 bis 500 mg Element/Liter Abscheidebad, vorzugsweise von 25 bis 100 mg Element/Liter Abscheidebad enthält.

4. Verfahren nach einem der vorstehenden Ansprüche, dadurch gekennzeichnet, daß zum Abscheiden der Kupferschichten zeitlich nacheinander Strom- und Spannungspulse mit verschiedener Stromstärke am Substrat eingestellt werden, wobei mindestens einer der Pulse kathodisch und mindestens ein anderer anodisch oder auf Null eingestellt wird.

5. Verfahren nach Anspruch 4, dadurch gekennzeichnet, daß die Dauer eines Strom- oder Spannungspulses von 0,3 Millisekunden auf bis zu 30 Millisekunden eingestellt wird.

6. Verfahren nach einem der vorstehenden Ansprüche zum elektrolytischen Abscheiden von Kupferschichten auf Leiterplattenoberflächen.

## Claims

1. Method of electrolytically depositing copper layers with a short operating time, having the following method steps:
a. preparing a deposition bath which contains copper ions, at least one compound which increases the electrical conductivity of the deposition bath, at least one additive to influence the material properties of the copper layers, at least one additional compound of an electrochemically reversible redox system and a solvent or solvent mixture,
b. bringing an electrically conductive substrate and at least one anode, which dissolves during the electrolytic deposition, in contact with the deposition bath, and
c. electrically connecting the substrate and the anodes to a power supply and depositing the copper layers on the substrate by means of a pulse current or pulse voltage method.

2. Method according to claim 1, characterised in that compounds of the elements iron, arsenic, cerium, chromium, cobalt, gold, manganese, molybdenum, platinum, ruthenium, samarium, titanium, vanadium, tungsten and/or tin are used as the compounds of the electrochemically reversible redox system.

3. Method according to one of the preceding claims, characterised in that the deposition solution contains the compounds of the redox system in a concentration from 3 to 500 mg element/litre deposition bath, preferably from 25 to 100 mg element/litre deposition bath.

4. Method according to one of the preceding claims, characterised in that, in order to deposit the copper layers in chronological succession, current and voltage pulses are set with variable current intensity on the substrate, at least one of the pulses being set cathodically and at least one other pulse being set anodically or to zero.

5. Method according to claim 4, characterised in that the duration of a current or voltage pulse is set to be between 0.3 milliseconds and 30 milliseconds.

6. Method according to one of the preceding claims for the electrolytic deposition of copper layers on printed circuit board surfaces.

## Revendications

1. Procédé de déposition électrolytique de couches de cuivre avec un temps de mise en oeuvre court comprenant les étapes suivantes :
a. Préparation d'un bain de déposition contenant des ions de cuivre, au moins un composé augmentant la conductibilité du bain de déposition, au moins un produit d'addition pour influencer les caractéristiques du matériau constitutif des couches de cuivre, au moins un composé supplémentaire d'un système d'oxydoréduction électrochimiquement réversible ainsi qu'un solvant ou un mélange de solvants,
b. mise en contact d'un substrat à conductibilité électrique et d'au moins une anode se dissolvant lors de la déposition électrolytique avec le bain de déposition,
c. raccordement du substrat et des anodes à une alimentation électrique et déposition des couches de cuivre sur le substrat au moyen d'un procédé à courant pulsé ou à tension pulsée.

2. Procédé selon la revendication 1, caractérisé en ce que des composés des éléments fer, arsenic, cérium, chrome, cobalt, or, manganèse, molybdène, platine, ruthénium, samarium, titane, vanadinite, tungstène et/ou étain sont utilisés comme composés du système d'oxydoréduction électrochimiquement réversible.

3. Procédé selon l'une des revendications précédentes, caractérisé en ce que la solution de déposition contient les composés du système d'oxydoréduction dans une concentration de 3 à 500 mg d'éléments par litre de bain de déposition, de préférence de 25 à 100 mg d'éléments par litre de bain de déposition.

4. Procédé selon l'une des revendications précédentes, caractérisé en ce que pour la déposition des couches de cuivre on règle chronologiquement sur le substrat des impulsions consécutives de courant et de tension de diverses puissances, au moins une des impulsions ayant un réglage cathodique et au moins une autre un réglage anodique ou de valeur zéro.

5. Procédé selon la revendication 4, caractérisé en ce que la durée d'une impulsion de courant ou de tension est réglée de 0,3 milliseconde à jusqu'à 30 millisecondes.

6. Procédé selon l'une des revendications précédentes pour la déposition électrolytique de couches de cuivre sur des surfaces de circuits imprimés.
